# EUROPEAN PATENT SPECIFICATION

(11) **EP 4 318 149 B1**
(45) Date of publication and mention of the grant of the patent: **21.10.2026**
(21) Application number: 22775182.3
(22) Date of filing: 11.03.2022
(51) Int. Cl.: G05B 19/05, H05K 7/14

(54) **MASTER UNIT**
MASTER-EINHEIT
UNITÉ MAÎTRE

(30) Priority: 24.03.2021 JP 2021050034
(43) Date of publication of application: 07.02.2024
(73) Proprietor: FANUC CORPORATION, Oshino-mura Minamitsuru-gun Yamanashi 401-0597 (JP)
(72) Inventor: SAEKI, Masahiro, Oshino-mura, Minamitsuru-gun, Yamanashi 401-0597 (JP); KUWAHATA, Shinichi, Oshino-mura, Minamitsuru-gun, Yamanashi 401-0597 (JP); MAEDA, Asunaro, Oshino-mura, Minamitsuru-gun, Yamanashi 401-0597 (JP)
(74) Representative: Schmidt, Steffen J.
(86) International application number: PCT/JP2022/010777
(87) International publication number: WO 2022/202390

(56) References cited:
- JP-A- 2002 091 519
- JP-A- 2011 130 307
- JP-A- 2016 110 460
- JP-A- 2018 157 456
- JP-A- 2019 114 085
- JP-A- 2021 002 172
- JP-A- H09 247 766
- US-A1- 2015 039 099
- US-A1- 2020 401 547

## Description

### TECHNICAL FIELD

The present invention relates to a master unit for transmitting signals to a device via an I/O unit.

### BACKGROUND ART

JP 2016-110460 A discloses a programmable logic controller system. The programmable logic controller system includes a base unit serving as a master, a plurality of expansion units (electronic devices) serving as slaves, and a controlled device. The base unit transmits and receives signals to and from the controlled device via the extension unit. The plurality of expansion units are consecutively connected, with the master unit being at the head. The controlled device is, for example, a device such as a sensor or an actuator.

US 2020/401547 A1 discloses a daisy chain connection system in which a plurality of information equipment are connected in a daisy chain. The system includes a plurality of slave enclosures, and one master enclosure which controls the slave enclosures. The master enclosure is a master unit of an outer covering which houses one or more components and devices therein.

US 2015/039099 A1 relates to a control device capable of reducing power consumption in a control system. A master unit is provided to control the operations of a plurality of I/O units. The master unit includes a processor, a field bus control unit, a reception unit, a transmission unit, and a internal bus control unit.

### SUMMARY OF THE INVENTION

According to the present invention, a master unit is set forth in claim 1. The master unit is also referred to as a communication coupler unit (or simply a coupler). A typical communication coupler unit includes a master processing circuit, connectors (two connectors), and a power supply unit. The master processing circuit is a circuit that performs signal processing with respect to communication with the slave unit. The two connectors include a connector for preceding-stage connection and a connector for subsequent-stage connection. The connector for preceding-stage connection can be connected to a control device that controls the communication coupler unit or another communication coupler unit. The connector for subsequent-stage connection can be connected to another communication coupler unit. Therefore, it is possible to daisy-chain connect a plurality of communication coupler units together.

Of the components as described above, the design of at least the master processing circuit varies depending on the application or purpose. For example, the optimum configuration of the master processing circuit differs for each type of industrial network. In addition, the configuration of the master processing circuit differs depending on, for example, safety/non-safety (with/without redundancy). An operator can properly use master units equipped with optimum master processing circuits, according to his/her purpose.

In contrast to the master processing circuit which is selectively used depending on the application or purpose, there is a strong tendency that the design of portions, of the communication coupler unit, other than the master processing circuit are standardized. For example, the connector described above can be used regardless of the type of industrial network or regardless of the presence or absence of redundancy. The power supply unit can also be used regardless of the type of industrial network or regardless of the presence or absence of redundancy. However, there is be a case where the specifications of portions other than the master processing circuit may be changed. Here, in a case where the plurality of communication coupler units have a common configuration with respect to portions other than the master processing circuit, the plurality of master units are subject to the specification change all at once. Moreover, in a general master unit (communication coupler unit), there is a case where the connector, the power supply unit, and the master processing circuit may be modularized. In other words, the master processing circuit is often integrated with the connector and the power supply unit. In this case, it is not easy for the operator to change the specification while leaving the master processing circuit unchanged.

The present invention has the object of solving the aforementioned problems.

According to an aspect of the present invention, there is provided a master unit connected to an I/O unit to which a device is connected, the master unit being configured to transmit a signal to the device through the I/O unit, the master unit including: a first connector configured to be connected to a control device or another master unit; a branch-line terminal configured to be connected to the I/O unit provided in a subsequent stage of the master unit; a master processing circuit connected to the first connector and the branch-line terminal; and a power supply unit configured to supply electric power to the master processing circuit, wherein the master unit includes: a connector module including the first connector and the power supply unit; and a signal processing module that is a module separated from the connector module and that includes the branch-line terminal and the master processing circuit, and each of the connector module and the signal processing module is provided with a connection terminal unit configured to connect the first connector and the power supply unit to the master processing circuit.

According to the aspect of the present invention, it is possible to provide a master unit in which a connector and a power supply unit can be easily changed.

### BRIEF DESCRIPTION OF DRAWINGS

FIG. 1 is a diagram illustrating a communication system according to a reference example of the present invention; and
FIG. 2 is a diagram showing a communication coupler unit according to an embodiment of the present invention.

### DETAILED DESCRIPTION OF THE INVENTION

Preferred embodiments of a master unit according to the present invention will be described in detail below with reference to the accompanying drawings.

### [Embodiments]

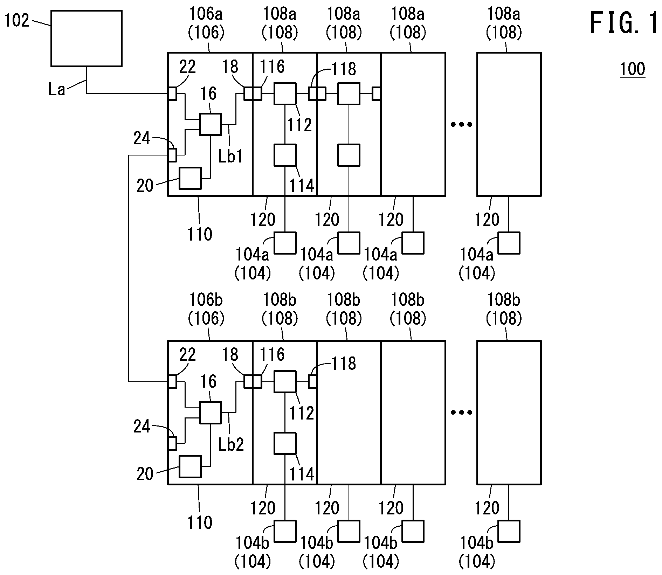

FIG. 1 is a diagram illustrating a communication system 100 according to a reference example of the present invention.

The communication system 100 is a system that transmits signals between a control device 102 and a device 104. The device 104 is provided in a mechanical apparatus. The mechanical apparatus is, for example, a machine tool or a robot. The device 104 includes an output device 104a and an input device 104b. The output device 104a is, for example, an actuator such as a switch. When driving the output device 104a, the control device 102 sends a control signal to the output device 104a via the communication system 100. The input device 104b is, for example, a sensor that detects pressure, voltage, current, or the like. The control device 102 acquires a detection signal from the input device 104b, via the communication system 100.

The communication system 100 includes a plurality of communication coupler units 106 (106a, 106b) and a plurality of I/O units 108. The I/O units 108 include a plurality of I/O units 108a and a plurality of I/O units 108b. The plurality of I/O units 108a are sequentially connected in the subsequent stage of the communication coupler unit 106a. That is, the communication coupler unit 106a is a master unit for the plurality of I/O units 108a, and each of the plurality of I/O units 108a is a slave unit of the communication coupler unit 106a. The plurality of I/O units 108b are sequentially connected in the subsequent stage of the communication coupler unit 106b. That is, the communication coupler unit 106b is a master unit for the plurality of I/O units 108b, and each of the plurality of I/O units 108b is a slave unit of the communication coupler unit 106b.

Each of the plurality of communication coupler units 106 includes a master processing circuit 16, a branch-line terminal 18, a power supply unit 20, a first connector 22, a second connector 24, and a housing 110. The housing 110 accommodates the master processing circuit 16, the branch-line terminal 18, the power supply unit 20, the first connector 22, and the second connector 24.

The master processing circuit 16 includes, for example, a central processing unit (CPU). However, the master processing circuit 16 may include an application specific integrated circuit (ASIC), a programmable logic device (PLD), a field programmable logic gate array (FPGA), or the like.

The power supply unit 20 supplies electric power to the master processing circuit 16. However, the power supply unit 20 may supply electric power to the plurality of I/O units 108.

Each of the first connector 22 and the second connector 24 is a connector for connection to the control device 102 or another communication coupler unit 106. In one communication coupler unit 106, the first connector 22 and the second connector 24 are connected to the master processing circuit 16.

The first connector 22 of the communication coupler unit 106a is connected to the control device 102. The second connector 24 of the communication coupler unit 106a is connected to the first connector 22 of the communication coupler unit 106b. Thus, the main line La shown in FIG. 1 is formed. The main line La extends from the control device 102, and then passes through the master processing circuit 16 of the communication coupler unit 106a and the master processing circuit 16 of the communication coupler unit 106b in this order.

The branch-line terminal 18 is a terminal for connection to the I/O unit 108. The branch-line terminal 18 is connected to the master processing circuit 16.

Each of the plurality of I/O units 108 includes a slave processing circuit 112, an interface 114, a preceding-stage branch-line terminal 116, a subsequent-stage branch-line terminal 118, and a housing 120. The housing 120 accommodates the slave processing circuit 112, the interface 114, the preceding-stage branch-line terminal 116, and the subsequent-stage branch-line terminal 118.

The slave processing circuit 112 includes, for example, a central processing unit (CPU). However, the slave processing circuit 112 may include an application specific integrated circuit (ASIC), a programmable logic device (PLD), a field programmable logic gate array (FPGA), or the like. The slave processing circuit 112 performs input/output of signals with respect to the master processing circuit 16.

The interface 114 is hardware (a circuit or an electronic component group) that connects the slave processing circuit 112 and the device 104. The slave processing circuit 112 and the device 104 perform input and output of signals to and from each other via the interface 114. The specific configuration of the interface 114 varies depending on the type of the device 104.

The plurality of I/O units 108 are connected to the plurality of devices 104. The plurality of I/O units 108 in FIG. 1 are connected respectively to the different devices 104. However, a plurality of devices 104 may be connected to one I/O unit 108.

The preceding-stage branch-line terminal 116 is a terminal for connection to another unit provided in the preceding stage of the I/O unit 108. The other unit provided in the preceding stage of the I/O unit 108 is, for example, the communication coupler unit 106 or another I/O unit 108. The subsequent-stage branch-line terminal 118 is a terminal for connection to another I/O unit 108 provided in the subsequent stage of the I/O unit 108. In one I/O unit 108, the preceding-stage branch-line terminal 116 and the subsequent-stage branch-line terminal 118 are connected to each other via the slave processing circuit 112.

When the communication coupler unit 106 and the I/O unit 108 are provided in this order, the preceding-stage branch-line terminal 116 of the I/O unit 108 is connected to the branch-line terminal 18 of the communication coupler unit 106. Thus, the slave processing circuit 112 of the I/O unit 108 is connected to the master processing circuit 16 of the communication coupler unit 106 provided in the preceding stage of the I/O unit 108.

The preceding-stage branch-line terminal 116 of the I/O unit 108 may be connected to the subsequent-stage branch-line terminal 118 of another I/O unit 108. As a result, a branch line (Lb1, Lb2) is formed in which the master processing circuit 16 of the communication coupler unit 106 and the slave processing circuits 112 of the plurality of I/O units 108 are sequentially connected.

When the control device 102 transmits a control signal to the device 104, the control device 102 outputs the control signal to the communication coupler unit 106a connected to the first stage (first) from the control device 102 itself. The control signal includes address information etc. of the I/O unit 108 to which the device 104 as a transmission target is connected. The master processing circuit 16 of the communication coupler unit 106a determines whether the address information included in the control signal indicates any one of the plurality of I/O units 108a. When the address information does not indicate any one of the plurality of I/O units 108a, the master processing circuit 16 of the communication coupler unit 106a outputs the control signal to the master processing circuit 16 of the communication coupler unit 106b. When the address information indicates any one of the plurality of I/O units 108a, the master processing circuit 16 of the communication coupler unit 106a outputs the control signal to the I/O unit 108a provided in the subsequent stage of the communication coupler unit 106a itself. The slave processing circuit 112 of the I/O unit 108a that has received the control signal from the preceding stage determines whether or not the address information included in the received control signal indicates the I/O unit 108a itself. When the address information indicates the I/O unit 108a itself, the slave processing circuit 112 of the I/O unit 108a outputs the control signal to the device 104 connected to the I/O unit 108a itself. Thus, the device 104 is caused to operate. On the other hand, when the address information included in the input control signal does not indicate the I/O unit 108a itself, the I/O unit 108a outputs the control signal to another I/O unit 108a provided in the subsequent stage of the I/O unit 108a itself. When the address information included in the control signal indicates the I/O unit 108 itself, the I/O unit 108 may output the control signal to another I/O unit 108 provided in the subsequent stage. In addition, when the address information included in the control signal indicates the I/O unit 108 connected to the communication coupler unit 106 itself, the communication coupler unit 106 may output the control signal to the next communication coupler unit 106 provided in the subsequent stage.

There is a case where the device 104 may output a signal to the control device 102. In this case, the signal of the device 104 is input to the slave processing circuit 112 of the I/O unit 108 to which the device 104 is connected. The slave processing circuit 112 transmits a signal input from the device 104 connected to the slave processing circuit 112 itself, to the control device 102. In this case, the slave processing circuit 112 outputs the signal to the I/O unit 108 or the communication coupler unit 106 connected to the preceding stage of the slave processing circuit 112 itself. Here, the slave processing circuit 112 adds the content output by the device 104 and the address information of the I/O unit 108 that has output the signal, to the output signal. The input and output of signals between the communication coupler unit 106 and the I/O unit 108 is a well-known technique and thus further description thereof is omitted.

As described above, the master processing circuit 16 has a plurality of variations. For example, the optimum configuration of the master processing circuit 16 differs for each type of industrial network. The industrial network is for example Ethernet, Profinet or EtherCAT. The configuration of the master processing circuit 16 also differs depending on safety network/non-safety network (with/without redundancy).

On the other hand, the configuration of the first connector 22 tends not to be changed in any of the communication coupler units 106. As an example, there are a first communication coupler unit 106 including a master processing circuit 16 for Profinet, for example, and a second communication coupler unit 106 including a master processing circuit 16 for EtherCAT. In this case, the first connector 22 of the first communication coupler unit 106 and the first connector 22 of the second communication coupler unit 106 are often of the same type. Also regarding the power supply unit 20 and the second connector 24, the second connectors are often of the same type in the plurality of communication coupler units 106.

If it is necessary to change the specification of at least one of the power supply unit 20, the first connector 22, or the second connector 24, in the worst case, all the communication coupler units 106 owned by the operator are subject to the specification change. Moreover, the master processing circuit 16, the power supply unit 20, the first connector 22, and the second connector 24 are configured as an integrated module. Therefore, it is not easy for the operator to disassemble the communication coupler unit 106 or change parts of the communication coupler unit 106.

In light of the above, a communication coupler unit 10 according to the present embodiment will be described below. Components similar to the components described in the reference example are denoted by the same reference numerals, description thereof is omitted, and portions different from the reference example will be mainly described.

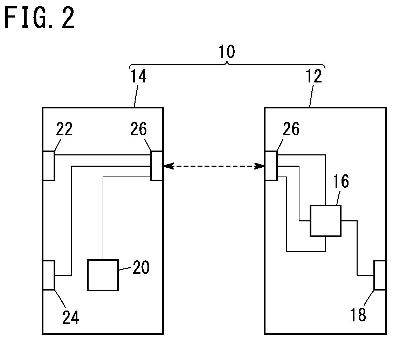

FIG. 2 is a diagram showing a communication coupler unit 10 according to an embodiment of the present invention.

The communication coupler unit (master unit) 10 is made up of a plurality of separable modules. That is, the communication coupler unit 10 includes a signal processing module 12 and a connector module 14. The signal processing module 12 includes a master processing circuit 16 and a branch-line terminal 18. Within the signal processing module 12, the master processing circuit 16 is connected to the branch-line terminal 18. The connector module 14 includes a power supply unit 20, a first connector 22, and a second connector 24.

Each of the signal processing module 12 and the connector module 14 further includes a connection terminal unit 26. The connection terminal unit 26 is a terminal unit (terminal group, connector) for interconnecting the signal processing module 12 and the connector module 14.

The connection terminal unit 26 includes a terminal (terminal group) for the power supply unit 20, a terminal (terminal group) for the first connector 22, and a terminal (terminal group) for the second connector 24. The connection terminal unit 26 of the signal processing module 12 is connected to the master processing circuit 16. On the other hand, the connection terminal unit 26 of the connector module 14 is connected to the power supply unit 20, the first connector 22, and the second connector 24.

The connection terminal unit 26 of the signal processing module 12 and the connection terminal unit 26 of the connector module 14 are connected to each other. For example, the connection terminal unit 26 of the signal processing module 12 and the connection terminal unit 26 of the connector module 14 are fitted to each other. Thus, the connection terminal unit 26 of the signal processing module 12 and the connection terminal unit 26 of the connector module 14 are connected to each other. The terminals for the power supply unit 20 are connected to each other. The terminals for the first connector 22 are connected to each other. The terminals for the second connector 24 are connected to each other. Accordingly, each of the power supply unit 20, the first connector 22, and the second connector 24 of the connector module 14 is connected to the master processing circuit 16 of the signal processing module 12 through the connection terminal unit 26.

The communication coupler unit 10 can be installed instead of the communication coupler unit 106. In this case, the signal processing module 12 and the connector module 14 are connected to each other. The control device 102 is connected to the first connector 22 of the connector module 14. Another communication coupler unit 10 is connected to the second connector 24. Accordingly, the control device 102, the communication coupler unit 10 (master processing circuit 16), and the other communication coupler unit 10 (master processing circuit 16) are connected to each other. Further, the plurality of I/O units 108 are sequentially connected to the branch-line terminal 18 of the signal processing module 12. Accordingly, the communication coupler unit 10 (the master processing circuit 16) and the plurality of I/O units 108 (the slave processing circuits 112) are connected to each other. The second connector 24 may be in an open state. That is, another communication coupler unit 10 may not be installed at the subsequent stage of the communication coupler unit 10. In this case, the second connector 24 of the communication coupler unit 10 is in an open state. In addition, the other communication coupler unit 10 installed at the subsequent stage of the communication coupler unit 10 may be the communication coupler unit 106.

The signal processing module 12 and the connector module 14 can be easily separated from each other by releasing the connection between the connection terminal units 26. Therefore, when a specification change occurs in the power supply unit 20, the first connector 22, and the second connector 24, the operator can easily achieve the change operation merely by reconnecting a new connector module 14 to the signal processing module 12.

The embodiment has been described above as an example of the present invention. It is noted that various modifications or improvements are capable of being added to the above-described embodiment. Further, other modes to which such modifications or improvements have been added can be included within the technical scope of the present invention as defined by the claims.

For example, if it is not necessary to provide another communication coupler unit 10 at the subsequent stage of the communication coupler unit 10, the second connector 24 itself may be omitted from the connector module 14.

In addition, the signal processing module 12 and the connector module 14 may be provided with an engagement mechanism for fitting the modules to each other. The engagement mechanism includes, for example, a claw and a groove having a shape that allows the claw to be caught. Further, the connection terminal units 26 themselves need not necessarily have a fitting structure as long as they can be electrically connected to each other.

## Claims

1. A master unit (10) connected to an I/O unit (108) to which a device (104) is connected, the master unit (10) being configured to transmit a signal to the device (104) through the I/O unit (108), the master unit (10) comprising:
a first connector (22) configured to be connected to a control device (102) or another master unit (10);
a branch-line terminal (18) configured to be connected to the I/O unit (108) provided in a subsequent stage of the master unit (10);
a master processing circuit (16) connected to the first connector (22) and the branch-line terminal (18); and
a power supply unit (20) configured to supply electric power to the master processing circuit (16),
**characterized in that**
the master unit (10) includes: a connector module (14) including the first connector (22) and the power supply unit (20); and a signal processing module (12) that is a module configured to be connectable to and separable from the connector module (14) and that includes the branch-line terminal (18) and the master processing circuit (16),
each of the connector module (14) and the signal processing module (12) is provided with a connection terminal unit (26) configured to connect the first connector (22) and the power supply unit (20) to the master processing circuit (16) in a connectable and separable manner.

2. The master unit (10) according to claim 1, wherein
the connector module (14) further includes a second connector (24) to which another master unit (10) is connected, and
the connection terminal unit (26) further connects the second connector (24) and the master processing circuit (16).

## Patentansprüche

1. Eine Master-Einheit (10), die mit einer E/A-Einheit (108) verbunden ist, an die ein Gerät (104) angeschlossen ist, wobei die Master-Einheit (10) so konfiguriert ist, dass sie ein Signal über die E/A-Einheit (108) an das Gerät (104) überträgt, wobei die Master-Einheit (10) umfasst:
einen ersten Anschluss (22), der so ausgelegt ist, dass er mit einer Steuervorrichtung (102) oder einer anderen Master-Einheit (10) verbunden werden kann;
einen Abzweiganschluss (18), der so ausgelegt ist, dass er mit der in einer nachfolgenden Stufe der Master-Einheit (10) vorgesehenen E/A-Einheit (108) verbunden werden kann;
eine Master-Verarbeitungsschaltung (16), die mit dem ersten Anschluss (22) und dem Abzweiganschluss (18) verbunden ist; und
eine Stromversorgungseinheit (20), die so ausgelegt ist, dass sie die Master-Verarbeitungsschaltung (16) mit elektrischer Energie versorgt,
**dadurch gekennzeichnet, dass**
die Master-Einheit (10) umfasst: ein Anschlussmodul (14), das den ersten Anschluss (22) und die Stromversorgungseinheit (20) enthält; und ein Signalverarbeitungsmodul (12), bei dem es sich um ein Modul handelt, das so ausgelegt ist, dass es mit dem Anschlussmodul (14) verbunden und von diesem getrennt werden kann, und das den Abzweiganschluss (18) und die Master-Verarbeitungsschaltung (16) enthält,
sowohl das Anschlussmodul (14) als auch das Signalverarbeitungsmodul (12) mit einer Verbindungs-Anschlusseinheit (26) versehen sind, die so ausgelegt ist, dass sie den ersten Anschluss (22) und die Stromversorgungseinheit (20) auf eine anschluss- und trennbare Weise mit der Master-Verarbeitungsschaltung (16) verbindet.

2. Die Master-Einheit (10) nach Anspruch 1, wobei
das Anschlussmodul (14) ferner einen zweiten Anschluss (24) umfasst, an den eine weitere Master-Einheit (10) angeschlossen ist, und
die Verbindungs-Anschlusseinheit (26) ferner den zweiten Steckverbinder (24) und die Master-Verarbeitungsschaltung (16) verbindet.

## Revendications

1. Unité maître (10) connectée à une unité d'E/S (108) à laquelle est connecté un dispositif (104), l'unité maître (10) étant configurée pour transmettre un signal au dispositif (104) par l'intermédiaire de l'unité d'E/S (108), l'unité maître (10) comprenant:
un premier connecteur (22) configuré pour être connecté à un dispositif de commande (102) ou à une autre unité maître (10);
une borne de dérivation (18) configurée pour être connectée à l'unité d'E/S (108) prévue à un étage suivant de l'unité maître (10);
un circuit de traitement maître (16) connecté au premier connecteur (22) et à la borne de dérivation (18); et
une unité d'alimentation électrique (20) configurée pour fournir de l'énergie électrique au circuit de traitement maître (16),
**caractérisé en ce que**
l'unité maître (10) comprend : un module de connexion (14) comprenant le premier connecteur (22) et l'unité d'alimentation (20); et un module de traitement de signaux (12) qui est un module configuré pour pouvoir être connecté au et en être séparé du module de connexion (14), et qui comprend la borne de dérivation (18) et le circuit de traitement maître (16),
le module de connexion (14) et le module de traitement du signal (12) sont chacun pourvus d' une unité de bornes de connexion (26) configurée pour relier le premier connecteur (22) et le bloc d'alimentation (20) au circuit de traitement maître (16) de manière à pouvoir être connectés et déconnectés.

2. L'unité maître (10) selon la revendication 1, dans laquelle
le module de connecteurs (14) comprend en outre un deuxième connecteur (24) auquel est connectée une autre unité maître (10), et
l'unité de bornes de connexion (26) relie en outre le deuxième connecteur (24) et le circuit de traitement maître (16).
